(19) Europäisches Patentamt

European Patent Office

Office européen des brevets

(11) **EP 4 773 332 A1**

(12) **EUROPEAN PATENT APPLICATION**

(43) Date of publication:
08.07.2026 Bulletin 2026/28

(21) Application number: 25226446.0

(22) Date of filing: 22.12.2025

(51) International Patent Classification (IPC):
*H01M 10/44* (2006.01)   *H01M 10/48* (2006.01)

(52) Cooperative Patent Classification (CPC):
H01M 10/44; H01M 10/48; H01M 10/482;
H01M 2010/4271

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 02.01.2025 KR 20250000453

(71) Applicant: SAMSUNG SDI CO., LTD.
Yongin-si, Gyeonggi-do 17084 (KR)

(72) Inventor: HA, Sangmin
17084 Yongin-si, Gyeonggi-do (KR)

(74) Representative: Gulde & Partner
Patent- und Rechtsanwaltskanzlei mbB
Berliner Freiheit 2
10785 Berlin (DE)

(54) **BATTERY SYSTEM AND METHOD OF CONTROLLING BATTERY SYSTEM**

(57)    A battery system (1) includes a battery module (10) and a measuring device (20) that (i) operates in a sleep mode or an active mode, (ii) performs a state measurement function of the battery module (10) during the active mode, and (iii) deactivates the state measurement function during the sleep mode. A control device (40) controls the measuring device (20) to alternately repeat the sleep mode and the active mode during an idle period of the battery system (1), estimates a full-charge arrival time or a full-discharge arrival time according to a present state of a battery cell (11) included in the battery module (10), and sets a wake-up cycle for transitioning the measuring device (20) from the sleep mode to the active mode using the full-charge arrival time or the full-discharge arrival time.

FIG. 1

**Description**

**BACKGROUND**

**(a) Field**

The present disclosure relates to a battery system and a method of controlling the battery system.

**(b) Description of the Related Art**

A rechargeable battery is a battery that is capable of being repeatedly charged and discharged, unlike a primary battery which is incapable of being recharged. Low-capacity rechargeable batteries are used for small portable electronic devices such as mobile phones, laptop computers, and camcorders. High-capacity rechargeable batteries are widely used as a power source for driving motors for such as hybrid vehicles and a power storage device. A rechargeable battery includes an electrode assembly formed of a positive electrode and a negative electrode, a case to accommodate the electrode assembly, and an electrode terminal connected to the electrode assembly.

More specifically, a rechargeable battery includes an electrode assembly including a positive electrode, a negative electrode, and a separator interposed between the positive electrode and the negative electrode, a case accommodating the electrode assembly, and an electrode terminal electrically connected to the electrode assembly. An electrolyte is injected into the case to enable charging and discharging of the battery through an electrochemical reaction of the positive electrode, the negative electrode, and the electrolyte solution. The shape of the case, such as a cylindrical or rectangular shape, varies depending on the intended use of the battery.

A battery system formed of a rechargeable battery is equipped with a measuring device for measuring a voltage, a current, a temperature, and the like of the rechargeable battery. The battery system performs charging and discharging control functions and protection functions according to the results of the measuring device. Typically, such a measuring device uses a rechargeable battery as an electric power source, which causes degradation in the energy efficiency of the battery system.

**SUMMARY**

The present disclosure provides a battery system that can increase energy efficiency of the battery system and a method of controlling the battery system. However, the problems solved by the present disclosure are not limited to the problems expressly described herein, and other problems solved by the present disclosure will be clearly understood by a person of an ordinary skill in the art from the description below.

One aspect of the present disclosure relates to a battery system, and a battery system according to an example may include: a battery module; a measuring device configured to (i) operate in a sleep mode or active mode, (ii) perform a state measurement function of the battery module during the active mode, and (iii) deactivate the state measurement function during the sleep mode; and a control device configured to (i) control the measuring device to alternately repeat the sleep mode and the active mode during an idle period of the battery system, (ii) estimate a full-charge arrival time or a full-discharge arrival time according to a present state of a battery cell included in the battery module, and (iii) set a wake-up cycle for transitioning the measuring device from the sleep mode to the active mode using the full-charge arrival time or the full-discharge arrival time.

The control device may be further configured to estimate the full-charge arrival time using a charge state of the battery cell, a full-charge capacity of the battery cell, and a predetermined maximum charge current, and may estimate the full-discharge arrival time using the charge state of the battery cell, the full-charge capacity of the battery cell, and a predetermined maximum discharge current.

The control device may be further configured to estimate the full-charge arrival time or the full-discharge arrival time by using a state of health of the battery cell.

The battery module may include a plurality of battery cells. The control device may be further configured to determine the full-charge arrival time or the full-discharge arrival time for each of the battery cells, and may determine the wake-up cycle based on the full-charge arrival time or the full-discharge arrival time of one of the battery cells.

The battery module may include a plurality of battery cells. The control device may be further configured to select one of the battery cells based on a present state of each of the battery cells and may estimate a full-charge arrival time or a full-discharge arrival time for the selected battery cell.

The control device may be further configured to determine the wake-up cycle using the full-charge arrival time if the charge state of the battery cell is higher than a predetermined value.

The control device may be further configured to determine the wake-up cycle using the full-discharge arrival time if the charge state of the battery cell is lower than the predetermined value.

A battery system according to another embodiment may include: a battery module; a measuring device configured to (i) operate in a sleep mode or active mode, (ii) perform a state measurement function of the battery module during the active mode, and (iii) deactivate the state measurement function during the sleep mode; and a control device configured to (i) control the measuring device to alternately repeat the sleep mode and the active mode during an idle period of the battery system and (ii) set a wake-up cycle for transitioning the measuring device from the sleep mode to the active mode according to a charge state of at least one battery cell included in the battery module.

The control device may be further configured to reduce the wake-up cycle as the charge state increases if the charge state is greater than a predetermined value and may reduce the wake-up cycle as the charge state decreases if the charge state is lower than the predetermined value.

The control device may be further configured to increase the wake-up cycle if a state of health of the battery cell increases and may decrease the wake-up cycle if the state of health of the battery cell decreases.

Another aspect of the present disclosure relates to a method of controlling a battery system including a battery module that may include: determining a wake-up cycle; and controlling a measuring device to alternately repeat a sleep mode and an active mode according to the wake-up cycle while the battery system is in an idle state. The determining may include estimating a full-charge arrival time or a full-discharge arrival time based on a present state of a battery cell of the battery module if the battery system is in the idle state; and setting the wake-up cycle using the full-charge arrival time or the full-discharge arrival time. The controlling may include controlling a timing at which the measuring device transitions from the sleep mode to the active mode according to the wake-up cycle. The measuring device may perform a state measurement function of the battery cell during the active mode and may deactivate the state measurement function during the sleep mode.

The present state may include a charge state of the battery cell.

The estimating may include estimating the full-charge arrival time using the charge state, a full-charge capacity of the battery cell, and a predetermined maximum charge current if the charge state is greater than a predetermined value. The setting may include setting the wake-up cycle using the full-charge arrival time if the charge state is greater than the predetermined value.

The estimating may include estimating the full-discharge arrival time using the charge state, the full-charge capacity of the battery cell, and a predetermined maximum discharge current, if the charge state is less than a predetermined value. The setting may include setting the wake-up cycle using the full-discharge arrival time if the charge state is less than the predetermined value.

The present state may include a state of health of the battery cell.

The battery system may include a plurality of battery cells.

The estimating may be performed for each of the battery cells. The setting may include setting the wake-up cycle using a full-charge arrival time or a full-discharge arrival time of one of the battery cells.

The determining may further include selecting one of the battery cells based on a present state of each of the battery cells. The estimating may be performed for the selected battery cell.

According to the present disclosure, the energy efficiency of the battery system can be increased by minimizing energy consumption caused by a measuring device.

However, the effects that can be obtained through the present disclosure are not limited to the effects described above, and other technical effects that are not mentioned would be clearly understood by a person of an ordinary skill in the art from the description of the invention described below.

## BRIEF DESCRIPTION OF THE DRAWINGS

The drawings illustrate preferred examples of the present disclosure, and together with the detailed description of the disclosure described below, serve to illustrate the technical ideas of the present disclosure. But the present disclosure should not be construed as being limited to embodiments depicted in the drawings.

FIG. 1 schematically illustrates a battery system according to an embodiment of the present disclosure.
FIG. 2 is a flowchart of a method of controlling a battery system according to an embodiment of the present disclosure.

## DETAILED DESCRIPTION OF THE EMBODIMENTS

Hereinafter, a preferred example of the present disclosure will be described in detail with reference to the accompanying drawings. Therefore, it should be understood that the examples described herein and the configurations shown in the drawings are only some of the most preferred examples of the present disclosure, and that various equivalents and modifications may be substituted for them at the time of filing the present application. It should be further understood that the terms "comprise(s)/include(s)" and/or "comprising/including" when used in this specification specify the presence of stated features, integers, steps, operations, elements, components or a combination thereof, but do not preclude the presence or addition of one or more other features, integers, steps, operations, elements, components, and/or groups thereof. In addition, when describing examples of the present disclosure, "may" and "is" may include "one or more examples of the present disclosure."

In addition, to aid understanding of the disclosure, the attached drawings are not drawn to scale and the dimensions of some components may be exaggerated. Further, like reference numbers may be assigned to like components in different examples.

When two things being compared are "the same," this means that they are "substantially the same."

Therefore, substantial equivalence may include deviations that are considered low in the art - -for example, deviations of less than 5 %. In addition, uniformity of a parameter in a given area may mean uniformity from an average perspective.

Although first, second, and the like are used to describe various configurations, these components are not limited by these terms. These terms are only used to distinguish one component from another, and unless otherwise stated, the first component may of course also be the second component.

Throughout the specification, unless otherwise specifically stated, each component may be singular or plural.

The placement of any configuration "on an upper portion (or a lower portion)" of a component or "on top (or bottom)" of a component may not only mean that any configuration is placed in contact with the upper surface (or bottom) surface of the component, but may also mean that other configurations may intervene between the component and any configuration placed above (or below) the component.

In addition, when it is stated that a component is "connected," "coupled," or "linked" to another component, it should be understood that the components may be directly connected or linked to one another, but that other components may also be "interposed" between each component, or that each component may be "connected," "coupled," or "linked" through another component. Further, when reference is made to a part being electrically connected (electrically coupled) to another part, this includes not only cases where they are directly connected, but also cases where they are connected with another element in between.

When reference is made throughout the specification to "A and/or B," this means A, B or A and B, unless otherwise specified. That is, "and/or" includes all combinations or any combination of the listed plurality of items. "C to D" means C or more and D or less, unless otherwise specified.

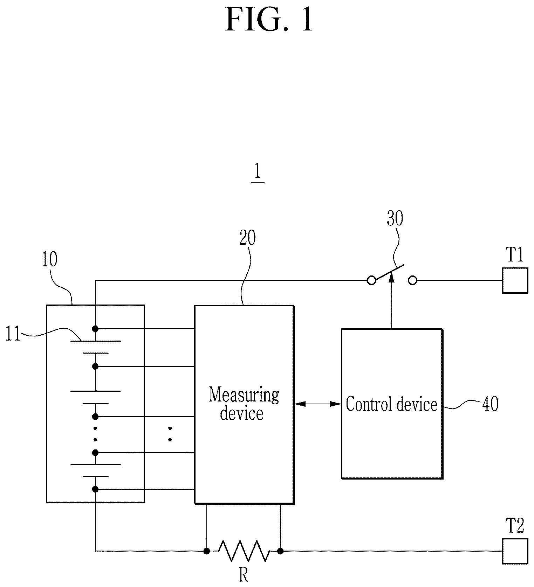

FIG. 1 schematically illustrates a battery system according to an example. Referring to FIG. 1, a battery system 1 according to an example may include system terminals T1 and T2, a battery module 10, a measuring device 20, a charging and discharging switch 30, and a control device 40.

The battery module 10 may include at least one battery cell 11 electrically connected between the system terminals T1 and T2. When the battery module 10 includes a plurality of battery cells 11, the plurality of battery cells 11 may be electrically connected between the system terminals T1 and T2 in series and/or in parallel.

The measuring device 20 may function to measure a state (a temperature, a voltage, a current, and the like) of the battery module 10. For example, the measuring device 20 may measure a cell voltage of each battery cell 11 in the battery module 10, a module voltage of the battery module 10, and the like. The measuring device 20 may also measure a current flowing through the battery module 10 through a shunt resistor R and the like. The measuring device 20 may further measure a temperature of the battery module 10 through a temperature sensor (not shown) and the like.

The measuring device 20 may operate in a sleep mode and an active mode. When entering the sleep mode, the measuring device 20 may stop state measurement of the battery module 10 and maintain a shut-down state. When entering the active mode, the measuring device 20 may activate the measurement function to measure a state of the battery module 10.

The measuring device 20 may include at least one integrated circuit (IC) (e.g., analog front end (AFE) IC).

The charging and discharging switch 30 may be disposed on a current path between the battery module 10 and the system terminals T1 and T2. The charging and discharging switch 30 may connect or disconnect the current path between the battery module 10 and the system terminals T1 and T2.

The control device 40 may perform the overall management function of the battery system 1. The control device 40 may receive state measurement values of the battery module 10 from the measuring device 20. The control device 40 may also estimate a state of charge (SOC) and a state of health (SOH) of the battery module 10 based on the state measurement values. The control device 40 may control on/off of the charging and discharging switch 30 depending on the state of the battery module 10. The control device 40 may also perform protection functions (overvoltage protection, overcurrent protection, overtemperature protection, overcharge protection, over-discharge protection, and the like) depending on the status of the battery module 10.

The control device 40 may also control mode conversion of the measuring device 20. In particular, the control device 40 may control the measuring device 20 to operate in the sleep mode or active mode. For example, the control device 40 may control the measuring device 20 to maintain the active mode during charge and discharge periods of the battery system 1. To identify the charge period and the discharge period of the battery system, the control device 40 may detect a current flow between the battery module 10 and the system terminals T1 and T2 through the measuring device 20.

The control device 40 may control the measuring device 20 to alternately switch between the sleep mode and the active mode during the idle period of the battery system 1. The control device 40 may monitor a current measurement result of the measuring device 20 to identify the idle period during which no current flows between the battery module 10 and the system terminals T1 and T2. For example, the control device 40 may determine that the battery system 1 is in the idle period when the current value is measured to be zero for more than a predetermined time period or measured to be zero for more than a predetermined number of times by the measuring device 20.

When the battery system 1 is determined to have entered the idle state, the control device 40 changes the measuring device 20 into the sleep mode to thereby shut down the measuring device 20. Then, when a predetermined time has elapsed from the time that the measuring device 20 enters the sleep mode, the control device 40 awakens the measuring device 20 to operate in the active mode. When the measuring device 20 in the active mode measures the state of the battery module 10, the control device 40 may determine whether to change the measuring device 20 back to the sleep mode according to the result of the measurement. That is, the control device 40 determines whether or not the battery system 1 maintains the idle state according to the measurement result, and the control device 40 may change the measuring device 20 back to the sleep mode when the battery system 1 has maintained the idle state. Through such a method, the control device 40 may iteratively control the measuring device 20 to alternately enter the sleep mode and the active mode during the idle period of the battery system 1.

When the measuring device 20, which has awakened from the sleep mode, performs measurements for each measurement item (voltage, current, temperature, and the like) more than or equal to a predetermined number of times (1 or more times), the control device 40 may determine whether to re-enter the sleep mode based on the current measurement result. For example, if the measuring device 20 performs one measurement for each of a voltage, a current, a temperature, and the like of the battery module 10, the control device 40 may determine whether to change the measuring device 20 to the sleep mode based on the measurement result.

The control device 40 maintains the measuring device 20 that has awakened from the sleep mode and entered the active mode for a predetermined time period, and then the control device 40 may determine whether the measurement device 20 should reenter the sleep mode based on the current measurement result. For example, when the measuring device 20 that has awakened from the sleep mode maintains the active mode for more than 10 minutes, the control device 40 may determine whether to switch the measuring device 20 to the sleep mode based on the measurement result.

A waiting time until the measuring device 20 switches from the sleep mode to the active mode (hereinafter referred to as a wake-up cycle) may vary depending on the present state of the battery module 10. The present state may include a present SOC and a present SOH of the battery cell 11 included in the battery module 10.

The control device 40 may estimate a full-charge arrival time or a full-discharge arrival time of the battery cell 11 based on the present SOC and the present SOH and determine the wake-up cycle of the measuring device 20 using the estimation result. The full-charge arrival time is a time period expected for the battery cell 11 to reach a full-charge state when charging the battery cell 11 with a predetermined current. The full-discharge arrival time is a time period expected for the battery cell 11 to reach a full-discharge state when discharging the battery cell 11 with a predetermined current.

The following Equations 1 and 2 show examples of calculating a full-charge arrival time Tc and a full-discharge arrival time Td, respectively.

[Equation 1]

$$Tc = ((1 - \frac{SOC}{100}) \times (\frac{SOH}{100} \times FCC))/Icmax$$

[Equation 2]

$$Td = (\frac{SOC}{100} \times (\frac{SOH}{100} \times FCC))/Idmax$$

In Equation 1 and Equation 2, SOC [%] and SOH [%] indicate a present SOC and a present SOH, respectively, of the battery cell 11. FCC is a full-charge capacity of the battery cell 11, which can be stored in advance in an internal memory (not shown) of the battery system 1 and used during the manufacturing of the battery system 1. The Icmax and Idmax represent a maximum charge current and a maximum discharge current, respectively, and may be stored in advance in the internal memory (not shown) of the battery system 1 and used during the manufacturing of the battery system 1.

The control device 40 may estimate the full-charge arrival time Tc of the battery cell 11 using Equation 1 when the present SOC of the battery cell 11 is greater than a predetermined value (e.g., 50%). In addition, the control device 40 may set a wake-up cycle using the estimated full-charge arrival time Tc. For example, when a full-charge capacity FCC of the battery cell 11 is 100 Ah, the present SOC and the present SOH of the battery cell 11 are 70% and 90%, respectively, and the maximum charge current is 50 A, then the full-charge arrival time Tc of the battery cell 11 may be $0.54 \text{ h} (= ((1- \frac{70}{100}) \times (\frac{90}{100} \times 100 \text{ Ah}))/50 \text{ A})$. Accordingly, the wake-up cycle of the measuring device 20 may be set to 0.54 hour.

The control device 40 may estimate the full-discharge arrival time Td using Equation 2 when the present SOC of the battery cell 11 is below a predetermined value (e.g., 50%). In addition, the control device 40 may set a wake-up cycle using the estimated full-discharge arrival time Td. For example, when the full-charge capacity FCC of the battery cell 11 is 100 Ah, the present SOC and the present SOH of the battery cell 11 are 30% and 90%, respectively, and the maximum discharge current is 50 A, then the full-discharge arrival time Td of the battery cell 11 may be $0.54 \text{ h} (=(\frac{30}{100} \times (\frac{90}{100} \times 100 \text{Ah})) /50\text{A})$. Accordingly, the wake-up cycle of the measuring device 20 may be set to 0.54 hour.

Further referring to Equations 1 and 2 above, when the present SOC of the battery cell 11 is greater than a predetermined value (e.g., 50%), the wake-up cycle of the measuring device 20 may become shorter as the SOC of the battery cell 11 increases, i.e., as the SOC of the battery cell 11 gets closer to the full-charge state (SOC 100%). On the other hand, when the present SOC of the battery cell 11 is below a predetermined value (e.g., 50%), the wake-up cycle of the measuring device 20 may become shorter as the SOC of the battery cell 11 decreases, i.e., as the SOC of the battery cell 11 gets closer to the full-discharge state (SOC 0%). In addition, the wake-up cycle of the measuring device 20 may increase as the SOH of the battery cell 11 increases, i.e., as the degree of degradation of the battery cell 11 decreases. In addition, the wake-up cycle of the measuring device 20 may decrease as the SOH of the battery cell 11 decreases, i.e., as the degree of degradation of the battery cell 11 increases.

When the battery module 10 includes a plurality of battery cells 11, the control device 40 may determine a full-charge arrival time Tc or a full-discharge arrival time Td for each of the battery cells 11. Then, the control device 40 may use the full-charge arrival time, which is the minimum of the full-charge arrival times of the battery cells 11, or the full-discharge arrival time, which is the minimum of the full-discharge arrival times of the battery cells 11, as the wake-up cycle of the measuring device 20.

When the battery module 10 includes a plurality of battery cells 11, the control device 40 may select a representative battery cell 11 from the plurality of battery cells 11 and use an SOC and an SOH of the representative battery cell 11 to determine the full-charge arrival time Tc or the full-discharge arrival time Td. Then, the control device 40 may use the full-charge arrival time Tc or the full-discharge arrival time Td as the wake-up cycle of the measuring device 20. In such an embodiment, the control device 40 may determine a battery cell 11 among the plurality of battery cells 11 having the lowest or highest present SOC as the representative battery cell. In addition, the control device 40 may determine a battery cell 11 among the plurality of battery cells 11 having the lowest or highest present SOH as the representative battery cell.

Once the wake-up cycle of the measuring device 20 is determined, the control device 40 may control a wake-up timing at which the measuring device 20 wakes up from the sleep mode during the idle period based on the wake-up cycle. That is, the control device 40 may awaken the measuring device 20 and switch it to the active mode when a time equal to the wake-up cycle has elapsed from the time that the measuring device 20 entered the sleep mode.

The control device 40 may include at least one processor for performing the functions of the control device 40 described above. Herein, a processor is a data processing device that has a physically structured circuit to perform a function expressed in a code or instruction included in a program. Examples of such a processor are a microprocessor, a central processing unit (CPU), a processor core, a multiprocessor, an application-specific integrated circuit (ASIC), or a field programmable gate array (FPGA).

The control device 40 may also be integrated into a battery management system (BMS) of the battery system 1.

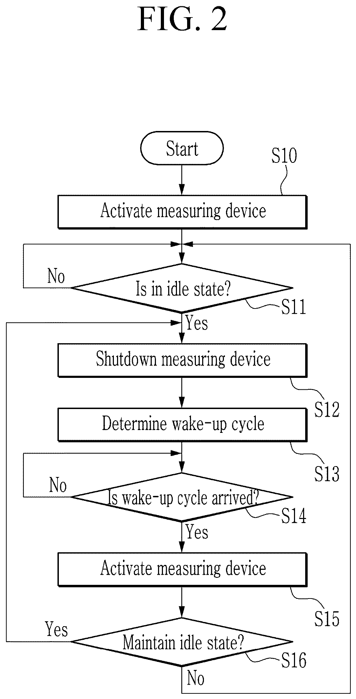

FIG. 2 is a flow chart of a method of controlling a battery system according to an embodiment of the present disclosure. The method of FIG. 2 may be performed by the control device 40 described above with reference to FIG. 1.

Referring to FIG. 2, when the operation of the battery system 1 is started, the control device 40 may first control the measuring device 20 to be activated such that the measuring device 20 measures the status of the battery module 10 (S10). The activated measuring device 20 may periodically measure a voltage, a temperature, a current, and the like of the battery module 10.

The control device 40 may determine whether the battery system 1 is in the idle state based on the measurement result of the measuring device 20 (S11). That is, the control device 40 checks a measurement result of the measuring device 20 to determine whether the battery module 10 is in the idle state during which no current flows between the battery module 10 and the system terminals T1 and T2.

When it is determined that the battery system 1 is not in the idle state, the control device 40 may control the measuring device 20 to maintain the active mode. When it is determined that the battery system 1 is in the idle state, the control device 40 may shut down the measuring device 20 (S12). When the measuring device 20 is shut down, the measurement function is deactivated and the measuring device 20 enters the sleep mode.

When the measuring device 20 enters the sleep mode, the control device 40 may determine the wake-up cycle for waking up the measuring device 20 from the sleep mode (S13). In S13, the control device 40 may determine the wake-up cycle of the measuring device 20 depending on the present state of the battery module 10. The control device 40 may estimate the full-charge arrival time Tc or the full-discharge arrival time Td of the battery module 10 using the present state of the battery module 10 and Equations 1 and 2 above. Next, the control device 40 may determine the wake-up cycle using the full-charge arrival time Tc or the full-discharge arrival time Td.

When the wake-up cycle arrives after the measuring device 20 has previously entered the sleep mode (S14) - that is, after a time period equivalent to the wake-up cycle has elapsed - the measuring device 20 may be reactivated to measure the state of the battery module 10 (S15). The measuring device 20 that has entered the active mode may measure the voltage, the temperature, the current, and the like of the battery module 10.

The control device 40 may determine whether the battery system 1 is in the idle state based on the measurement result of the measuring device 20 (S16). In S16, when the measuring device 20 awakened from the sleep mode performs measurement for each measurement item (voltage, current, temperature, etc.) for more than or equal to a predetermined number of times (e.g., 1 time), the control device 40 may determine whether the measuring device 20 should reenter the sleep mode based on the measurement result. The control device 40 may maintain the activated state of the measuring device 20 that has awakened from the sleep mode for a predetermined time, and then the control device 40 may determine whether to reenter the sleep mode based on the measurement result.

When it is determined that the battery system 1 is in the idle state in S16, the control device 40 may shut down the measuring device 20 (S12). The shut-down measuring device 20 enters the sleep mode and remains in the sleep state until the next wake-up cycle comes.

When it is determined that the battery system 1 is not in the idle state in S16 - i.e., when it is determined that the battery system 1 is being charged or discharged - the control device 40 maintains the measuring device 20 in the active state until the battery system 1 becomes the idle state again.

In the above-described embodiment, the battery system 1 may minimize energy consumption by changing the measuring device 20 to the shut-down state during the idle period. In addition, the battery system 1 may protect the battery module 10 from overcharge/over-discharge of the battery module 10 by periodically activating the measuring device 20 during the idle period. Further, the battery system 1 may maximize energy efficiency during the idle period of the measuring device 20 by adjusting the wake-up cycle of the measuring device 20 according to the present state of the battery module 10.

The examples described above are not limited to the devices and/or methods described above, but may also be implemented through a program that realizes a function corresponding to the configuration of the examples, or a computer-readable recording medium on which the program is recorded. Such alternative implementations can easily be implemented by a person skilled in the art to which the present disclosure belongs based on the present disclosure.

As used herein, computer-readable recording media includes any type of recording device that stores data that can be read by a computer system. Examples of computer-readable storage devices include ROM, RAM, CD-ROM, DVD_ROM, DVD_RAM, magnetic tape, floppy disk, hard disk, and optical data storage devices.

Although the present disclosure has been described above through examples and drawings, the present disclosure is not limited thereto. Various modifications and variations are possible within the technical scope of the present disclosure as defined by the appended claims.

**<Description of symbols>**

1: battery system
10: battery module
11: battery cell
20: measuring device
30: charging and discharging switch
40: control device
R: shunt resistor
T1, T2: system terminal

**Claims**

1. A battery system (1) comprising:

   a battery module (10);
   a measuring device (20) configured to (i) operate in a sleep mode or an active mode, (ii) perform a state measurement function of the battery module (10) during the active mode, and (iii) deactivate the state measurement function during the sleep mode; and
   a control device (40) configured to (i) control the measuring device (20) to alternately repeat the sleep mode and the active mode during an idle period of the battery system (1), (ii) estimate a full-charge arrival time or a full-discharge arrival time according to a present state of a battery cell (11) included in the battery module (10), and (iii) set a wake-up cycle for transitioning the measuring device (20) from the sleep mode to the active mode using the full-charge arrival time or the full-discharge arrival time.

2. The battery system (1) as claimed in claim 1, wherein the control device (40) is further configured to:

   estimate the full-charge arrival time using a charge state of the battery cell (11), a full-charge capacity of the battery cell (11), and a predetermined maximum charge current; and
   estimate the full-discharge arrival time using the charge state of the battery cell (11), the full-charge capacity of the battery cell (11), and a predetermined maximum discharge current.

3. The battery system (1) as claimed in claim 1 or 2, wherein the control device (40) is further configured to estimate the full-charge arrival time or the full-discharge arrival time by using a state of health of the battery cell (11).

4. The battery system (1) as claimed in any one of claims 1 to 3, wherein the battery module (10) comprises a plurality of battery cells (11), and
   wherein the control device (40) is further configured to:

   determine the full-charge arrival time or the full-discharge arrival time for each of the battery cells (11); and
   determine the wake-up cycle based on the full-charge arrival time or the full-discharge arrival time of one of the battery cells (11).

5. The battery system (1) as claimed in any one of claims 1 to 3, wherein the battery module (10) comprises a plurality of battery cells (11), and
   wherein the control device (40) is further configured to:

   select one of the battery cells (11) based on a present state of each of the battery cells (11); and
   estimate the full-charge arrival time or the full-discharge arrival time for the selected battery cell (11).

6. The battery system (1) as claimed in any one of the preceding claims, wherein the control device (40) is further configured to determine the wake-up cycle using the full-charge arrival time if a charge state of the battery cell (11) is higher than a predetermined value.

7. The battery system as claimed in any one of the preceding claims, wherein the control device (40) is further configured to determine the wake-up cycle using the full-discharge arrival time if the charge state of the battery cell (11) is lower than the predetermined value.

8. A battery system (1) comprising:

   a battery module (10);
   a measuring device (20) configured to (i) operate in a sleep mode or an active mode, (ii) perform a state measurement function of the battery module (10) during the active mode, and (iii) deactivate the state measurement function during the sleep mode; and
   a control device (40) configured to (i) control the measuring device (20) to alternately repeat the sleep mode and the active mode during an idle period of the battery system (1) and (ii) set a wake-up cycle for transitioning the measuring device (20) from the sleep mode to the active mode according to a charge state of at least one battery cell (11) included in the battery module (10),
   wherein the control device (40) is further configured to:

reduce the wake-up cycle as the charge state increases if the charge state is greater than a predetermined value; and
reduce the wake-up cycle as the charge state decreases if the charge state is lower than the predetermined value.

9. The battery system (1) as claimed in claim 8, wherein the control device (40) is further configured to:

increase the wake-up cycle if a state of health of the battery cell (11) increases; and
decrease the wake-up cycle if the state of health of the battery cell (11) decreases.

10. A method of controlling a battery system (1) including a battery module (10), the method comprising:

determining a wake-up cycle; and
controlling a measuring device (20) to alternately repeat a sleep mode and an active mode according to the wake-up cycle while the battery system (1) is in an idle state,
wherein the determining comprises:

estimating a full-charge arrival time or a full-discharge arrival time based on a present state of a battery cell (11) of the battery module (10) if the battery system (1) is in the idle state; and
setting the wake-up cycle using the full-charge arrival time or the full-discharge arrival time,

wherein the controlling comprises controlling a timing at which the measuring device (20) transitions from the sleep mode to the active mode according to the wake-up cycle, and
wherein the measuring device (20) performs a state measurement function of the battery cell (11) during the active mode and deactivates the state measurement function during the sleep mode.

11. The method as claimed in claim 10, wherein the present state includes a charge state of the battery cell (11), and

wherein, if the charge state is greater than a predetermined value, the estimating includes estimating the full-charge arrival time using the charge state, the full-charge capacity of the battery cell (11), and a predetermined maximum charge current; and/or
wherein, if the charge state is greater than the predetermined value, the setting comprises setting the wake-up cycle using the full-charge arrival time.

12. The method as claimed in claim 10, wherein the present state includes a charge state of the battery cell (11), and

wherein, if the charge state is less than a predetermined value, the estimating includes estimating the full-discharge arrival time using the charge state, the full-charge capacity of the battery cell (11), and a predetermined maximum discharge current; and/or
wherein, if the charge state is less than the predetermined value, the setting comprises setting the wake-up cycle using the full-discharge arrival time.

13. The method as claimed in any one of claims 10 to 12, wherein the present state comprises a state of health of the battery cell (11).

14. The method as claimed in any one of claims 10 to 13, wherein the battery system (1) comprises a plurality of battery cells (11),

wherein the estimating is performed for each of the battery cells (11), and
wherein the setting comprises setting the wake-up cycle using a full-charge arrival time or a full-discharge arrival time of one of the battery cells (11).

15. The method as claimed in any one of claims 10 to 13, wherein the battery system (1) comprises a plurality of battery cells (11),

wherein the determining further comprises selecting one of the battery cells (11) based on a present state of each of the battery cells (11), and
wherein the estimating is performed for the selected battery cell (11).

# FIG. 1

<u>1</u>

Measuring device

Control device ~40

R

T1

T2

10

11

20

30

# FIG. 2

Start — S10

↓

Activate measuring device

No ← Is in idle state? — S11

↓ Yes

Shutdown measuring device — S12

↓

Determine wake-up cycle — S13

↓

No ← Is wake-up cycle arrived? — S14

↓ Yes

Activate measuring device — S15

↓

Yes ← Maintain idle state? — S16

No

Europäisches
Patentamt

European
Patent Office

Office européen
des brevets

# EUROPEAN SEARCH REPORT

**Application Number**

EP 25 22 6446

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 026 752 A1 (SAMSUNG SDI CO LTD [KR]) 1 June 2016 (2016-06-01)<br>* paragraph [0006] *<br>* paragraph [0029] - paragraph [0030] *<br>* paragraph [0035] - paragraph [0036] *<br>* paragraph [0063] - paragraph [0065] *<br>* paragraph [0039] *<br>* paragraph [0070] *<br>* figure 1 *<br>* figure 4 *<br>----- | 1-15 | INV.<br>H01M10/44<br>H01M10/48 |
| A | US 2019/004115 A1 (NAKAMURA YOHEI [JP] ET AL) 3 January 2019 (2019-01-03)<br>* paragraph [0064] *<br>* figure 7 *<br>----- | 1-15 | |
| A | CA 2 788 893 A1 (EAGLEPICHER TECHNOLOGIES LLC [US]) 12 March 2013 (2013-03-12)<br>* paragraph [0015] - paragraph [0016] *<br>----- | 1-15 | |

**TECHNICAL FIELDS SEARCHED (IPC)**

H01M

The present search report has been drawn up for all claims

| Place of search | Date of completion of the search | Examiner |
|---|---|---|
| Munich | 30 April 2026 | Ogor, Pascal |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
............................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 22 6446

This annex lists the patent family members relating to the patent documents cited in the above-mentioned European search report.
The members are as contained in the European Patent Office EDP file on
The European Patent Office is in no way liable for these particulars which are merely given for the purpose of information.

30-04-2026

| Patent document cited in search report | | Publication date | Patent family member(s) | | Publication date |
|---|---|---|---|---|---|
| EP 3026752 | A1 | 01-06-2016 | CN | 105655654 A | 08-06-2016 |
| | | | EP | 3026752 A1 | 01-06-2016 |
| | | | KR | 20160063756 A | 07-06-2016 |
| | | | US | 2016156202 A1 | 02-06-2016 |
| US 2019004115 | A1 | 03-01-2019 | CN | 108291944 A | 17-07-2018 |
| | | | EP | 3410137 A1 | 05-12-2018 |
| | | | JP | 6595009 B2 | 23-10-2019 |
| | | | JP | WO2017130673 A1 | 12-07-2018 |
| | | | US | 2019004115 A1 | 03-01-2019 |
| | | | WO | 2017130673 A1 | 03-08-2017 |
| CA 2788893 | A1 | 12-03-2013 | CA | 2788893 A1 | 12-03-2013 |
| | | | CN | 102998626 A | 27-03-2013 |
| | | | CN | 107576912 A | 12-01-2018 |
| | | | EP | 2568303 A2 | 13-03-2013 |
| | | | JP | 5753140 B2 | 22-07-2015 |
| | | | JP | 2013061337 A | 04-04-2013 |
| | | | US | 2013066573 A1 | 14-03-2013 |

EPO FORM P0459

For more details about this annex : see Official Journal of the European Patent Office, No. 12/82